# EUROPÄISCHE PATENTSCHRIFT

(11) **EP 1 611 484 B1**
(45) Veröffentlichungstag und Bekanntmachung des Hinweises auf die Patenterteilung: **10.11.2021**
(21) Anmeldenummer: 04721821.9
(22) Anmeldetag: 19.03.2004
(51) Int. Cl.: H01L 51/44, B82Y 10/00

(54) **PHOTOAKTIVES BAUELEMENT MIT ORGANISCHEN SCHICHTEN**
PHOTOACTIVE COMPONENT COMPRISING ORGANIC LAYERS
COMPOSANT PHOTO-ACTIF PRESENTANT DES COUCHES ORGANIQUES

(30) Priorität: 19.03.2003 DE 10313232
(43) Veröffentlichungstag der Anmeldung: 04.01.2006
(73) Patentinhaber: Heliatek GmbH, 01139 Dresden (DE)
(72) Erfinder: DRECHSEL, Jens, 01307 Dresden (DE); PFEIFFER, Martin, 01139 Dresden (DE); MÄNNIG, Bert, 01099 Dresden (DE); LEO, Karl, 01219 Dresden (DE)
(86) Internationale Anmeldenummer: PCT/DE2004/000574
(87) Internationale Veröffentlichungsnummer: WO 2004/083958

(56) Entgegenhaltungen:
- WO-A-00/33396
- WO-A-99/49525
- US-B1- 6 278 055
- PFEIFFER M ET AL: "Controlled p-doping of pigment layers by cosublimation: Basic mechanisms and implications for their use in organic photovoltaic cells" SOLAR ENERGY MATERIALS AND SOLAR CELLS, ELSEVIER SCIENCE PUBLISHERS, AMSTERDAM, NL, Bd. 63, Nr. 1, Juni 2000 (2000-06), Seiten 83-99, XP004201249 ISSN: 0927-0248
- MEISSNER D ET AL .: "HIGHLY EFFICIENT MOLECULAR ORGANIC SOLAR CELLS" 16TH. E.C. PHOTOVOLTAIC SOLAR ENERGY CONFERENCE. GLASCOW, UNITED KINGDOM, MAY 1 - 5, 2000, PROCEEDINGS OF THE INTERNATIONAL PHOTOVOLTAIC SOLAR ENERGY CONFERENCE, LONDON : JAMES & JAMES LTD, GB, Bd. VOL. 1 OF 3. CONF. 16, 1. Mai 2000 (2000-05-01), Seiten 10-14, XP001138231 ISBN: 1-902916-18-2
- YAKIMOV A ET AL: "High photovoltage multiple-heterojunction organic solar cells incorporating interfacial metallic nanoclusters" APPLIED PHYSICS LETTERS, AMERICAN INSTITUTE OF PHYSICS. NEW YORK, US, Bd. 80, Nr. 9, 4. März 2002 (2002-03-04), Seiten 1667-1669, XP012031741 ISSN: 0003-6951 in der Anmeldung erwähnt
- STOLZ ROMAN L ET AL: "TRAPPING LIGHT IN POLYMER PHOTODIODES WITH SOFT EMBOSSED GRATINGS" ADVANCED MATERIALS, VCH VERLAGSGESELLSCHAFT, WEINHEIM, DE, Bd. 12, Nr. 3, 3. Februar 2000 (2000-02-03), Seiten 189-195, XP000923550 ISSN: 0935-9648
- LANE P A ET AL: "Electroabsorption studies of phthalocyanine/perylene solar cells" SOLAR ENERGY MATERIALS AND SOLAR CELLS, ELSEVIER SCIENCE PUBLISHERS, AMSTERDAM, NL, Bd. 63, Nr. 1, Juni 2000 (2000-06), Seiten 3-13, XP004201242 ISSN: 0927-0248
- HUANG JINGSONG ET AL: "Low-voltage organic electroluminescent devices using pin structures" APPLIED PHYSICS LETTERS, AMERICAN INSTITUTE OF PHYSICS. NEW YORK, US, Bd. 80, Nr. 1, 7. Januar 2002 (2002-01-07), Seiten 139-141, XP012030202 ISSN: 0003-6951
- GEBEYEHU D ET AL: "Bulk-heterojunction photovoltaic devices based on donor-acceptor organic small molecule blends" SOLAR ENERGY MATERIALS AND SOLAR CELLS, ELSEVIER SCIENCE PUBLISHERS, AMSTERDAM, NL, Bd. 79, Nr. 1, August 2003 (2003-08), Seiten 81-92, XP004446739 ISSN: 0927-0248
- DRECHSEL J ET AL: "High efficiency organic solar cells based on single or multiple PIN structures" PREPARATION AND CHARACTERIZATION, ELSEVIER SEQUOIA, NL, [Online] Bd. 451-452, 22. März 2004 (2004-03-22), Seiten 515-517, XP004495157 ISSN: 0040-6090 Gefunden im Internet: URL:www.sciencedirect.com> [gefunden am 2005-08-25]
- Martin Pfeiffer: "Controlled Doping of Organic Vacuum Deposited Dye Layers: Basics and Applications" In: "Controlled Doping of Organic Vacuum Deposited Dye Layers: Basics and Applications", 16 December 1999 (1999-12-16), TU Dresden, Germany, XP055476771,

## Beschreibung

Die Erfindung betrifft ein photoaktives Bauelement mit organischen Schichten, insbesondere eine Solarzelle, gemäß Anspruch 1.

Seit der Demonstration der ersten organischen Solarzelle mit einem Wirkungsgrad im Prozentbereich durch Tang et al. 1986 [C.W. Tang et al. Appl. Phys. Lett. 48, 183 (1986)], werden organische Materialien intensiv für verschiedene elektronische und optoelektronische Bauelemente untersucht. Organische Solarzellen bestehen aus einer Folge dünner Schichten (typischerweise 1nm bis 1µm) aus organischen Materialien, welche bevorzugt im Vakuum aufgedampft oder aus einer Lösung aufgeschleudert werden. Die elektrische Kontaktierung erfolgt in der Regel durch Metallschichten und/oder transparente leitfähige Oxide (TCOs).

Eine Solarzelle wandelt Lichtenergie in elektrische Energie um. Im Gegensatz zu anorganischen Solarzellen werden bei organischen Solarzellen durch das Licht nicht direkt freie Ladungsträger erzeugt, sondern es bilden sich zunächst Exzitonen, also elektrisch neutrale Anregungszustände (gebundene Elektron-Loch-Paare). Erst in einem zweiten Schritt werden diese Exzitonen in freie Ladungsträger getrennt, die dann zum elektrischen Stromfluss beitragen.

Der Vorteil solcher Bauelemente auf organischer Basis gegenüber den konventionellen Bauelementen auf anorganischer Basis (Halbleiter wie Silizium, Galliumarsenid) sind die teilweise extrem hohen optischen Absorptionskoeffizienten (bis zu 2 × 10⁵ cm⁻¹), so dass sich die Möglichkeit bietet, mit geringem Material- und Energieaufwand sehr dünne Solarzellen herzustellen. Weitere technologische Aspekte sind die niedrigen Kosten, die Möglichkeit, flexible großflächige Bauteile auf Plastikfolien herzustellen, und die nahezu unbegrenzten Variationsmöglichkeiten der organischen Chemie.

Eine in der Literatur bereits vorgeschlagene Realisierungsmöglichkeit einer organischen Solarzelle besteht in einer pin-Diode [Martin Pfeiffer, "Controlled doping of organic vacuum deposited dye layers: basics and applications", PhD thesis TU-Dresden, 1999.] mit folgendem Schichtaufbau:
0.Träger, Substrat,
1.Grundkontakt, meist transparent,
2. n-Schicht (en) (bzw. p),
3. i-Schicht(en)
4. p-Schicht(en) (bzw. n),
5. Deckkontakt.

Hierbei bedeutet n bzw. p eine n- bzw. p-Dotierung, die zu einer Erhöhung der Dichte freier Elektronen bzw. Löcher im thermischen Gleichgewichtszustand führt. In diesem Sinne sind derartigen Schichten primär als Transportschichten zu verstehen. Eine oder mehrere i-Schicht(en) können hierbei Schichten sowohl aus einem Material, als auch aus sogenannten interpenetrierenden Netzwerken bestehen. Das durch den transparenten Grundkontakt einfallende Licht erzeugt in der i-Schicht bzw. in der n-/p-Schicht Exzitonen. Diese Exzitonen können nur durch sehr hohe elektrische Felder oder an geeigneten Grenzflächen getrennt werden. In organischen Solarzellen stehen ausreichend hohe Felder nicht zur Verfügung, so dass alle Erfolg versprechenden Konzepte für organische Solarzellen auf der Exzitonentrennung an photoaktiven Grenzflächen beruhen.

Die Exzitonen gelangen durch Diffusion an eine derartige aktive Grenzfläche, wo Elektronen und Löcher voneinander getrennt werden. Diese kann zwischen der p-(n-)Schicht und der i-Schicht bzw. zwischen zwei i-Schichten liegen. Im eingebauten elektrischen Feld der Solarzelle werden die Elektronen nun zum n-Gebiet und die Löcher zum p-Gebiet abtransportiert.

Da durch das Licht immer erst Exzitonen erzeugt werden und noch keine freien Ladungsträger, spielt die rekombinationsarme Diffusion von Exzitonen an die aktive Grenzfläche eine kritische Rolle bei organischen Solarzellen. Um einen Beitrag zum Photostrom zu leisten, muss daher in einer guten organischen Solarzelle die Exzitonendiffusionslänge die typische Eindringtiefe des Lichts deutlich übersteigen, damit der überwiegende Teil des Lichts genutzt werden kann. Strukturell und bezüglich der chemischen Reinheit perfekte organische Kristalle oder Dünnschichten erfüllen durchaus dieses Kriterium. Für großflächige Anwendungen ist allerdings die Verwendung von monokristallinen organischen Materialien nicht möglich und die Herstellung von Mehrfachschichten mit ausreichender struktureller Perfektion ist bis jetzt noch sehr schwierig.

Statt die Exzitonendiffusionslänge zu vergrößern, kann man auch den mittleren Abstand bis zur nächsten Grenzfläche verkleinern. Aus WO 00/33396 ist die Bildung eines sogenannten interpenetrierenden Netzwerkes bekannt: Eine Schicht enthält eine kolloidal gelöste Substanz, die so verteilt ist, dass sich ein Netzwerk bildet, über das Ladungsträger fließen können (Perkolationsmechanismus). Die Aufgabe der Lichtabsorption übernimmt in einem solchen Netzwerk entweder nur eine der Komponenten oder auch beide. Der Vorteil dieser Mischschicht ist, dass die erzeugten Exzitonen nur einen sehr kurzen Weg zurücklegen müssen bis sie an eine Domänengrenze gelangen, wo sie getrennt werden. Der Abtransport der Elektronen bzw. Löcher erfolgt getrennt in der gelösten Substanz bzw. in der übrigen Schicht. Da in der Mischschicht die Materialien überall miteinander im Kontakt sind, ist bei diesem Konzept entscheidend, dass die getrennten Ladungen eine lange Lebensdauer auf dem jeweiligen Material besitzen und von jedem Ort aus geschlossene Perkolationspfade für beide Ladungsträgersorten zum jeweiligen Kontakt hin vorhanden sind. Mit diesem Ansatz konnten Wirkungsgrade von 2,5% erreicht werden [C. J. Brabec, N. S. Sariciftci, J. C. Hummelen, Advanced Functional Materials 11, 15 (2001)].

Weitere bekannte Ansätze zur Realisierung bzw. Verbesserung der Eigenschaften von organischen Solarzellen sind im Folgenden aufgezählt:
1.) Ein Kontaktmetall hat eine große und das andere eine kleine Austrittsarbeit, so dass mit der organischen Schicht eine Schottky-Barriere ausgebildet wird [US 4127738].
2.) Die aktive Schicht besteht aus einem organischen Halbleiter in einem Gel oder Bindemittel [US 03844843, US 0390045, US 04175981 und US 04175982].
3.) Herstellung einer Transportschicht, die kleine Partikel (Größe 0.01 - 50 µm) enthält, welche den Ladungsträgertransport übernehmen [US 5965063].
4.) Eine Schicht enthält zwei oder mehr Arten von organischen Pigmenten, die verschiedene spektrale Charakteristika besitzen [JP 04024970].
5.) Eine Schicht enthält ein Pigment, das die Ladungsträger erzeugt, und zusätzlich ein Material, das die Ladungsträger abtransportiert [JP 07142751].
6.) Polymerbasierende Solarzellen, die Kohlenstoffteilchen als Elektronenakzeptoren enthalten [US 05986206].
7.) Dotierung von o.g. Mischsystemen zur Verbesserung der Transporteigenschaften in Mehrschichtsolarzellen [Patentantrag - Aktenzeichen: DE 102 09 789.5-33],
8.) Anordnung einzelner Solarzellen übereinander (Tandemzelle) [US 04461922, US 06198091 und US 06198092].

Aus US 5,093,698 ist die Dotierung organischer Materialien bekannt: Durch Beimischung einer akzeptorartigen bzw. donatorartigen Dotiersubstanz wird die Gleichgewichtsladungsträgerkonzentration in der Schicht erhöht und die Leitfähigkeit gesteigert. Nach US 5,093,698 werden die dotierten Schichten als Injektionsschichten an der Grenzfläche zu den Kontaktmaterialien in elektrolumineszierenden Bauelementen verwendet. Ähnliche Dotierungsansätze sind analog auch für Solarzellen zweckmäßig.

Trotz der oben beschriebenen Vorteile bei interpenetrierenden Netzwerken besteht ein kritischer Punkt darin, dass in der Mischschicht geschlossene Transportpfade für sowohl Elektronen als auch Löcher zu ihren jeweiligen Kontakten vorhanden sein müssen. Da außerdem die einzelnen Materialien jeweils nur einen Teil der Mischschicht ausfüllen, verschlechtern sich die Transporteigenschaften für die Ladungsträger im Vergleich zu den reinen Schichten deutlich.

Aufgrund von geringen Exzitonendiffusionslängen bzw. Transport- und Rekombinationsproblemen in interpenetrierenden Netzwerken sind die aktiven Schichtdicken von organischen Solarzellen meist geringer als die Eindringtiefe des Lichtes. Zudem weisen organische Farbstoffe nur einzelne Absorptionsbanden auf, so dass ein Material nie das komplette optische Spektrum abdecken kann. Deswegen ist es wünschenswert so genannte Lichtfallen (light trapping) zu verwenden [L.S. Roman.u.a. Trapping Light in Polyymer Photodiodes with soft embossed gratings. Advanced materials 2000 12, No. 3 S. 189-195] oder mehrere Zellen aufeinander stapeln zu können. Derartige Stapelzellen wurden erstmals von Yakimov et al. [A. Yakimov, S. R. Forrest, Appl. Phys. Lett. 80 (9), 1667 (2002).] realisiert. Sie bestehen aus zwei Schichten pro Einzelzelle und benötigen Rekombinationszentren an der Grenzfläche zwischen den einzelnen Zellen. Bringt man wie Yakimov diese Rekombinationszentren direkt auf das photoaktive Material auf, so sorgen sie nicht nur für die gewünschte Rekombination von Ladungsträgern aus der n-ten Zelle mit entgegen gesetzten Ladungsträgern aus der n+1-ten Zelle, sondern sie bilden auch nicht erwünschte Rekombinationszentren für Exzitonen oder Ladungsträgerpaare aus ein und derselben Zelle. Daraus ergeben sich entweder Rekombinationsverluste oder inaktive Bereiche. Zur Vermeidung dieser Effekte müssen die Schichten dicker gemacht werden als es der Breite der jeweils photoaktiven Zone entspricht, so dass Absorption in Bereichen auftritt, wo sie nicht genutzt werden kann. Ein derartiges Problem tritt in analoger Weise auch in Einzeldiodenstrukturen auf. Hierbei treten die Rekombinationsverluste jedoch unmittelbar an den Übergängen zwischen aktiver Schicht und Kontaktelektrode auf.

Der Erfindung liegt somit die Aufgabe zugrunde, Rekombinationsverluste oder das Auftreten inaktiver Bereiche bei Solarzellen mit organischen Schichten weitgehend zu verringern.

Erfindungsgemäß wird die Aufgabenstellung durch die kennzeichnenden Merkmale des Anspruches 1 gelöst. Besonders günstige Ausgestaltungen der Erfindung sind in den Unteransprüchen dargestellt.

Vorliegende Erfindung zielt auf die Realisierung von Solarzellen ab, die aus mehreren aufeinander gestapelten pi-, ni- oder pin-DiodenStrukturen)bestehen.

Eine pi-, ni- oder pin-Dioden-Struktur wird nachfolgend einfach als Struktur bezeichnet, sofern nicht im Einzelfall eine der drei Strukturen im Besonderen gemeint ist.

Hierbei bezeichnet p mindestens eine p-dotierte Schicht (p-Schicht), i mindestens eine im elektrischen Sinne undotierte oder nur vergleichsweise gering dotierte Schicht (i-Schicht), von denen mindestens eine Photonen absorbiert und zur Generation des Stromes beiträgt, und n mindestens eine n-dotierte Schicht (n-Schicht).

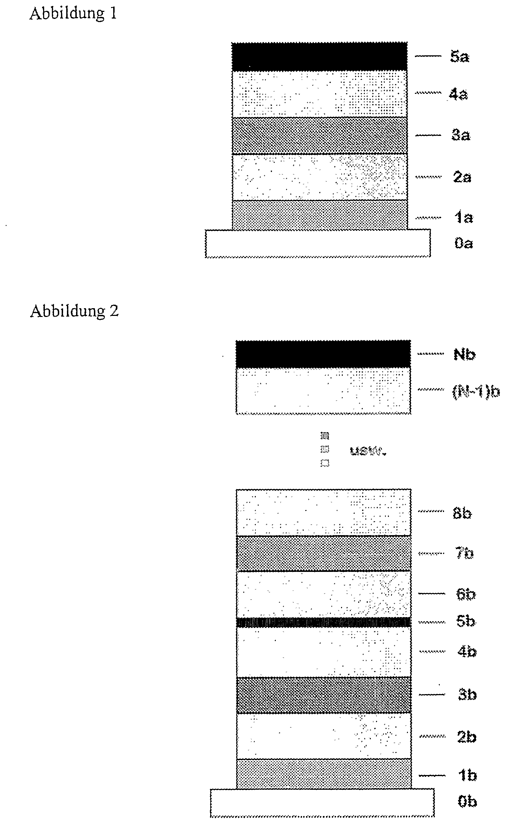

Die Lösung der Aufgabenstellung und des zuletzt beschriebene Problems des Standes der Technik wird erfindungsgemäß dadurch möglich, dass die Rekombinationszone bzw. die Kontaktelektrode durch Schichten mit erhöhter Bandlücke (wide-gap Schichten) von den aktiven Bereichen separiert wird, in denen weder Exzitonen noch Minoritätsladungsträger existieren, die rekombinieren könnten. Weiterhin dienen sie dem Schutz der i-Schicht als aktive Schicht vor destruktiven Einflüssen vor, während und nach der Abscheidung von Kontaktschichten bzw. optionalen Rekombinationszonen. Bei den wide-gap Transportschichten (in Abb. 2 als 2b, 4b, 6b, 8b usw. bezeichnet) handelt es sich um Materialien, deren Absorptionsverhalten sich wesentlich von dem der aktiven Schichten unterscheidet. Besonders vorteilhaft ist es, wenn sie nur im UV- bzw. UV-nahen Bereich des sichtbaren Sonnenspektrums absorbieren. Somit wird sichergestellt, dass die wesentliche Absorption in den aktiven Schichten stattfindet. Zudem wird erreicht, dass Exzitonen an den Übergängen zu den wide-gap Schichten reflektiert und nicht dem photoaktiven Prozess entzogen werden. Die Transporteigenschaften in den wide-gap p- bzw. n-Schichten für Majoritätsladungsträger sind durch entsprechende p- bzw. n-Dotierung gegenüber undotierten Schichten entscheidend verbessert, so dass die Schichtdicken in einem weiten Bereich variiert werden können, um das Maximum des optischen Feldes auf die aktiven i-Schichten zu konzentrieren und somit zu optimieren. Die Anforderungen nach Maximierung der eingebauten Spannung in den einzelnen Diodenstrukturen, und nach verlustarmer Rekombination an deren Grenzfläche, wird ebenfalls durch n- bzw. p-Dotierung der wide-gap-Schichten erreicht. Eine Vergrößerung des Wegs des einfallenden Lichtes und damit eine Umsetzung in eine hohe interne und externe Quantenausbeute wird auch durch die vorteilhafte Ausgestaltung gemäß Anspruch 8 erreicht. Durch die Möglichkeit, beliebig viele Strukturen aufeinander zu stapeln (Anspruch 3), können die einzelnen Strukturen so dünn gehalten werden, dass sie nur geringe Rekombinationsverluste und damit eine hohe interne und externe Quantenausbeute aufweisen. Die Zellenstruktur vereint somit einen geringen Serienwiderstand, eine maximale Photospannung und eine optimale Umsetzung des Photonenstroms in einen Photostrom.

Durch eine Schicht oder eine Kombination von Schichten, wie sie im Anspruch 1 angegeben sind, wird die verlustarme Rekombination in Sperrrichtung oder die Generation in Durchlassrichtung an den Übergängen zwischen den einzelnen Strukturen begünstigt. Außerdem wird die Morphologie der Übergänge zwischen der n-ten und der n + 1-ten pi-, ni- oder pin-Struktur begünstigt.

Eine solche Schicht kann als Diffusionssperre für Dotanden oder andere in der technologischen Folge nachfolgender Materialien oder zum Zwecke eines induzierten Wachstums der nachfolgenden Schichten dienen. Diese Schicht kann aus einer oder mehreren dotierten funktionellen Schichten aus einem organischen oder anorganischem Halbleitermaterial, oder aus einer Schicht aus einem Salz oder einem transparenten leitfähigen Oxid, oder mehrerer dieser Schichten bestehen.

Die Generation des Photostromes in der i-Schicht des erfindungsgemäßen photoaktiven Elementes beruht auf einem oder einer Kombination der nachfolgenden Wirkprinzipien:
a) Absorption von Photonen mit daraus resultierender Exzitonenbildung und Trennung der Exzitonen in freie Ladungsträger durch ein elektrisches Feld
b) Absorption von Photonen in einem ersten Material mit daraus resultierender Exzitonenbildung, Diffusion der Exzitonen an eine Grenzfläche zu einem weiteren Material und Trennung der Exzitonen in freie Ladungsträger an der Grenzfläche.
c) Absorption der Photonen durch eine oder mehrere Komponenten eines mehrkomponentigen Materials, das zumindest aus den Komponenten K1 und K2 besteht, Trennung der auf K1 oder K2 entstandenen Exzitonen in Elektronen auf K1 und Löcher auf K2 und Abtransport der Ladungsträger in einem interpenetrierenden Netzwerk der beiden Komponenten.
d) Generation entsprechend in einer Schicht oder einem Schichtsystem, welches mindestens eine p- oder n-dotierte mehrkomponentige Schicht umfasst.

In einer Ausführungsform der Erfindung weist die Dotierungsdichte in einer oder mehreren der photoaktiven Schichten (3a bzw. 3b,7b, usw.) oder Transportschichten (2a,4a bzw. 2b,4b,6b,8b usw.) einen Gradienten auf, wobei die Dotierungsdichte in den Transportschichten in Richtung der aktiven Schicht sinkt.

In einer weiteren Ausführungsform der Erfindung ist mindestens ein Dotand ein anorganisches Material, insbesondere ein Alkalimetall.

In einer weiteren Ausführungsform der Erfindung besteht mindestens ein Anteil in der photoaktiven Schichten (3a bzw. 3b,7b usw.) ganz oder teilweise aus anorganischen Materialien.

In einer weiteren Ausführungsform der Erfindung besteht mindestens ein Anteil der Ladungstransportschichten (2a,4a bzw. 2b,4b,6b,8b usw.) ganz oder teilweise aus anorganischen Materialien.

In einer weiteren Ausführungsform der Erfindung werden für die p-Dotierung der Löchertransportschichten organische Akzeptormoleküle aus der Klasse der Chinone, Tetracyanochinodimethane (TCNQ-Derivate), Dicyanochinochinodiimine (DCNQI-Derivate) und entsprechende Derivate höherer Chinone (Naphto- und Anthrochinonderivate) verwendet.

In einer weiteren Ausführungsform der Erfindung wird als Wirtsmaterial für die p-Transportschichten ein Material aus den folgenden Materialklassen verwendet:
a) Derivate von Tetraphenyldiamin (TPD), insbesondere solche TPD-Derivate, deren Ionisierungsenergie durch elektronenschiebende Substituenten wie Methoxy- oder Methylgruppen erniedrigt wird, sowie deren Spiro-Derivate,
b) Triphenylamin-Derivate, insbesondere Derivate von Tris(Diphenylamino)-Triphenylamin (TDATA), Triaminophenyl-Derivate, Triphenylbenzen-Derivate und
c) Oliqomere, die durch Verwendung von Thiophenringen Donorcharakter erhalten, insbesondere Oligothiophene
d) Derivate von Oligo-para-Phenylen-Vinylen (OPPV)
e) Porphyrine oder PhthalozyanineT
f) Perylen oder Terrylenderivate.

In einer weiteren Ausführungsform der Erfindung wird als Wirtsmaterial für die n-Transportschichten ein Material aus den folgenden Materialklassen verwendet:
a) Derivate von Pervlen- oder Naphthalen-Tetracarbonsäure-Diirnid (PTCDI, NTCDI), -Dianhydrid (PTCDA, NTCDA) oder -Bisimidazol (PTCBI, NTCBI)
b)_ Fullerene wie C60 oder C70 und deren Derivate,
c) Phthalozyanine oder Porphyrine, deren Elektronenaffinität durch elektronenziehende Substituenten wie Fluor oder Chlor erhöht wurde
d) Chinone
e) Oligomere mit durch Substituenten wie Fluor, Chlor, CF3, CN etc. erhöhter Elektronenaffinität, z.B. perfluorierte Oligophenyle
f)_ Oxadiazol-Derivate.

In einer weiteren Ausführungsform der Erfindung sind in den photoaktiven Schichten (3a bzw. 3b,7b usw.) vorwiegend donorartige Substanzen aus den oben erwähnten Materialklassen und vorwiegend akzeptorartige Substanzen aus den oben erwähnten Materialklassen enthalten.

Die Erfindung soll nachfolgend anhand zweier Ausführungsbeispiel näher erläutert werden. In den zughörigen Zeichnungen zeigt
Abb. 1 eine organischen Solarzelle nach dem Prinzip einer Einzeldiodenstruktur (Stand der Technik),
Abb. 2 eine erfindungsgemäßen organischen Solarzelle nach Stapelprinzip (zweites Ausführungsbeispiel)
Abb. 3a ein photoaktives Bauelements nach dem Stapelprinzip, welches aus zwei pin-Zellen besteht,
Abb. 3b ein Energieschema der in 3a dargestellten photoaktiven Bauelementes,
Abb. 4 eine Schichtabfolge der Zweifachstruktur (nicht Teil der beanspruchten Erfindung) und
Abb. 5 je eine Hell- und eine Dunkelkennlinie.

Eine in Abb. 1 (Stand der Technik) dargestellte Struktur einer organischen Solarzelle nach Prinzip einer Einzeldiodenstruktur beinhaltet folgende Schichten:
0a.) Träger, Substrat,
1a.) Grundkontakt, meist transparent, mit optionaler organischer oder anorganischer Kontaktvermittlungsschicht
2a.) Ladungsträgertransportschicht (wide-gap), p- bzw. n-dotiert
3a.) aktive Schicht,
4a.) Ladungsträgertransportschicht (wide-gap), n- bzw. p-dotiert
5a.) Deckkontakt, darunter optional organische oder anorganische Kontaktvermittlungsschicht

Demgemäß besteht das Bauelement vorteilhaft aus einer pin- bzw. nip-Schichtstruktur. Die pin- (bzw. nip-) Struktur ihrerseits besteht jeweils aus zwei oder mehr organischen Ladungsträgertransportschichten (2a und 4a) und einem zwischen der organischen Schicht (2a) und der organischen Schicht (4a) befindlichen Schichtsystem (3a), in welchem das Licht absorbiert wird. Weiterhin beinhaltet die komplette Struktur 2 Kontaktschichten (1a und 5a) die jeweils auch als transparente Kontaktschicht ausgeführt sein kann. Die Schichten 2a bzw. 4a sind p bzw. n-dotiert, die Schicht 3a ist undotiert oder sehr gering p- bzw. n-dotiert. Die Schicht 3a ist entweder einkomponentig (abgesehen von der Dotierung) oder es handelt sich um Mischschichten aus zwei Komponenten entsprechend dem Prinzip interpenetrierender Netzwerke. Die Materialien sind so gewählt, dass Exzitonen an den internen Phasengrenzen in der Mischschicht zwischen den beiden Materialien bzw. an der Grenzschicht zweier Schichten effizient in freie Ladungsträger getrennt werden.

Wie in Abb. 2 dargestellt, beinhaltet eine vorteilhafte Ausführung einer Struktur einer erfindungsgemäßen organischen Solarzelle nach Stapelprinzip folgende Schichten:
0b.) Träger, Substrat,
1b.) Grundkontakt, meist transparent, mit optionaler organischer oder anorganischer Kontaktvermittlungsschicht
2b.) Ladungsträgertransportschicht (wide-gap), p- bzw. n-dotiert
3b.) erste aktive Schicht,
4b.) Ladungsträgertransportschicht (wide-gap), n- bzw. p-dotiert
5b.) Übergangsschicht, Rekombinationszone
6b.) Ladungsträgertransportschicht (wide-gap), p- bzw. n-dotiert
7b.) zweite aktive Schicht,
8b.) Ladungsträgertransportschicht (wide-gap), n- bzw. p-dotiert usw.
   (N-1)b.) Ladungsträgertransportschicht (wide-gap), n- bzw. p-dotiert
Nb.) Deckkontakt, darunter optional organische oder anorganische Kontaktvermittlungsschicht

Demgemäß besteht das Bauelement vorteilhaft aus mindestens zwei gestapelten pin- bzw. nip- Schichtstrukturen. Die pin- (bzw. nip-) Strukturen ihrerseits bestehen jeweils aus zwei oder mehr organischen Ladungsträgertransportschichten (2b und 4b, 6b und 8b usw.) und einem zwischen der organischen Schicht (2b, 6b usw.) und der organischen Schicht (4b, 8b usw.) befindlichen Schichtsystem (3b, 7b usw.), in welchem das Licht absorbiert wird. Weiterhin beinhaltet die komplette Stapelstruktur zwei Kontaktschichten (1b und Nb) sowie jeweils ein Übergangsschichtsystem zwischen n-ten und der n+1-ten pin-(nip-)Zelle, die jeweils auch als transparente Kontaktschicht ausgeführt sein kann. Die Schichten 2b, 6b etc. bzw. 4b, 8b etc. sind p-bzw. n-dotiert, die Schicht 3b, 7b etc. ist undotiert oder sehr gering p- bzw. n-dotiert. Die Schicht 3b, 7b etc. ist entweder einkomponentig (abgesehen von der Dotierung) oder es handelt sich um Mischschichten aus zwei Komponenten entsprechend dem Prinzip interpenetrierender Netzwerke. Die Materialien sind so gewählt, dass Exzitonen an den internen Phasengrenzen in der Mischschicht zwischen den beiden Materialien bzw. an der Grenzschicht zweier Schichten effizient in freie Ladungsträger getrennt werden.

Die Ladungsträgertransportschichten 2b, 4b, 6b etc. müssen nicht photoaktiv sein. Erfindungsgemäß ist in jeder Diodenstrukturen mindestens eine der Transportschichten, welche an den Übergang zwischen zwei Strukturen angrenzt, dotiert. Jede Ladungsträgertransportschicht sorgt für den effizienten Abtransport einer Ladungsträgersorte (Löcher bzw. Elektronen). Außerdem trennen sie die aktiven Schichten von den Kontakten bzw. den Rekombinationsschichten 5b, 9b etc. und verhindern damit, dass die Exzitonen oder Ladungsträgerpaare aus einer Diode unerwünschte Rekombinationszentren antreffen.

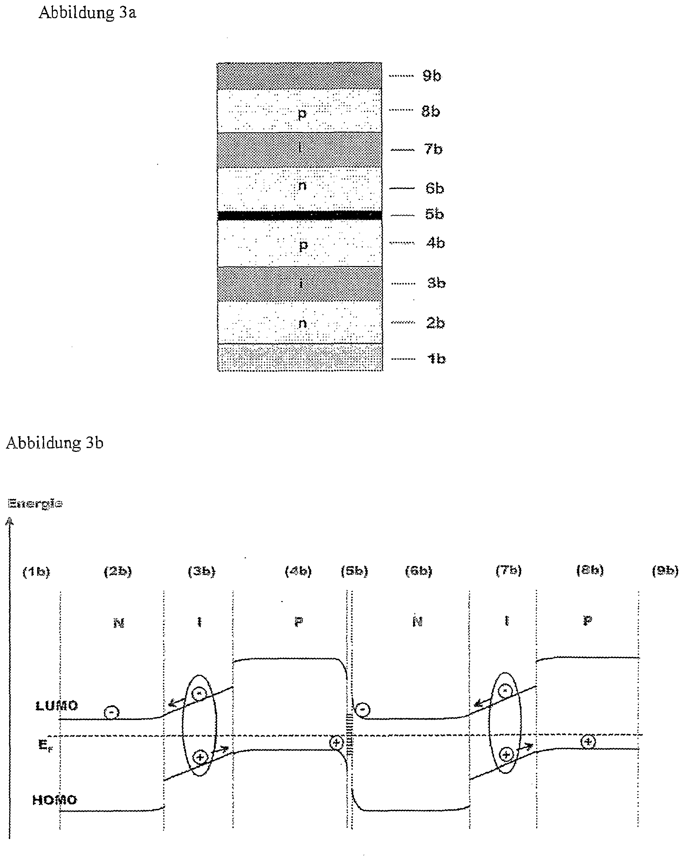

Zur Veranschaulichung wird die Funktionsweise am Beispiel eines photoaktiven Bauelements erläutert, welches aus zwei pin-Zellen besteht. Einfach und mehrfach pin-Zellen funktionieren analog. Eine derartige Stapelzelle ist in Abb. 3a und deren Energieschema in Abb. 3b dargestellt. Zur besseren Übersicht sei ebenfalls angenommen, dass die Transportschichten, die aktiven Schichten und die Übergangsschichten jeweils nur aus einer Einzelschicht bestehen. Hierbei sollen die aktiven Schichten der ersten pin-Zelle (3b) einen anderen Absorptionsbereich abdecken als die der pin-Zelle zwei (7b), um einen möglichst weiten Spektralbereich auszunutzen. Des Weiteren sei angenommen, dass die aktiven Schichten im Sinne der interpenetrierenden Netzwerke aus einer Mischung je zweier Materialien bestehen. Durch das Licht soll nun in dem undotierten Material der ersten Mischschicht (3b) ein Exziton erzeugt werden. Das Exziton diffundiert in diesem Material bis es an eine Domänengrenze innerhalb der Mischschicht gelangt. Hier wird es getrennt, wobei das Loch auf dem donorartigen Material und das Elektron auf dem akzeptorartigen Material verbleibt. Beide Ladungsträger wandern anschließend zu den entsprechenden dotierten Transportschichten. Hierbei ist ein guter Übergang gewährleistet und die jeweilige Ladungsträgertransportschicht sorgt für den effizienten Transport des Elektrons zum Kontakt (1b) bzw. des Lochs zur Übergangsschicht (5b). Analog vollzieht sich der Vorgang in der zweiten pin-Zelle (6b), (7b), (8b). Nun liegen an den beiden Kontakten (1b), (9b) die Ladungsträger vor. Um jedoch einen Stromfluss zu gewährleisten, müssen die beiden Ladungsträger, welche in Richtung der Übergangsschicht (5b) abgegeben wurden, miteinander rekombinieren, womit der Stromkreis geschlossen ist. Bei dieser Rekombination soll nur ein möglichst geringer Energieverlust auftreten. Dies wird, wie unten näher erläutert, durch die Dotierung von mindestens einer der angrenzenden Tansportschichten, welche an den Übergang zwischen zwei Strukturen angrenzt, und durch den Einbau der Übergangsschicht (5b) erreicht. Bei Benutzung hoch dotierter Transportschichten ist unter Umständen eine derartige Übergangsschicht nicht notwendig (nicht Teil der beanspruchten Erfindung).

Besonders wichtig in derartigen Stapelzellen ist die Balance der erzeugten Ströme in den Einzelzellen, d.h. die Anzahl der absorbierten und in Ladungsträger umgewandelten Photonen. Erfindungsgemäß wird dies durch eine Anpassung der Schichtdicken und/oder der Wahl der Materialien mit entsprechend verschiedenem Absorptionsvermögen gewährleistet.

Die Funktionsweise des Bauelementes wird nachfolgend an Hand des Energieschemas noch näher erläutert. Abb. 3b zeigt die schematische Darstellung der HOMO (highest occupied molecular orbital) und LUMO (lowest unoccupied molecular orbital) Niveaus am Beispiel einer zweifachen pin-Stapelstruktur. Auch hier ist vereinfachend nur jeweils eine Schicht für Ladungsträgergeneration (aktive Schicht, 3b und 7b), Löchertransport (4b und 8b), Elektronentransport (2b und 6b) dargestellt. Durch das Licht soll nun wiederum in jeder aktiven Schicht ein Exziton erzeugt werden. Dieses kann nun nahezu vor Ort in ein Loch und ein Elektron zerfallen (vgl. interpenetrierende Netzwerke) oder aber auch soweit diffundieren bis es innerhalb der aktiven Schicht an eine trennende Grenzschicht trifft wobei es dissoziiert.

Erfindungsgemäß wird bei einem Diffusionsprozess der Exzitonen gewährleistet, dass nicht getrennte Exzitonen durch die angrenzenden wide-gap Transportschichten reflektiert werden und weiterhin zur Dissoziation, und somit zur Ladungsträgergeneration, zur Verfügung stehen. Die entstandenen Ladungsträger werden durch das eingebaute Feld, welches durch das Angleichen der verschiedenen Ferminiveaus der n- bzw. p-dotierten Schichten (2b, 6b bzw. 4b, 8b) entsteht, bis an die Grenzen der aktiven Schichten transportiert und können von den Transportschichten übernommen werden.

Vorzugsweise sind die Materialien so zu wählen, dass der Ladungsübergang zwischen aktiver Schicht und den Transportschichten nur für eine Ladungsträgerart (Elektronen zur n-Schicht, Löcher zur p-Schicht) energetisch möglich ist. In einer vorteilhaften Ausführung stoßen hier die Energieniveaus, wie in Abb. 3b dargestellt, iso-energetisch aneinander. Für die jeweils andere Art besteht eine energetische Barriere.

Ladungsträger in den Schichten 2b und 8b können direkt auf den Kontakt 1b bzw. 9b übergehen. Hierbei wirkt sich die Dotierung der Transportschichten positiv aus, da der Übergang zu Kontakten auch mit nicht ideal angepassten Austrittsarbeiten durch eine starke Bandverbiegung und somit durch eine Reduzierung der Verarmungszone erleichtert wird (quasi-ohmscher Kontakt). Ladungsträger in den Schichten 4b (Löcher) und 6b (Elektronen) gehen auf die Übergangsschicht (5b) über, wo sie rekombinieren können. Ihr Übergang wird besonders durch den eben erklärten vorteilhaften Einfluss der Dotierung (quasi-ohmscher Kontakt) begünstigt.

Die Konzentration des optischen Feldes zwecks erhöhter Absorption in den aktiven Bereichen durch optimale Wahl optischer Konstanten und Schichtdicken der Transportschichten ist ebenfalls Gegenstand der Erfindung.

Im Sinne der Erfindung sind die Ladungstransportschichten vorzugsweise dotiert (im Sinne einer elektrisch wirksamen Dotierung). Im Falle molekularer organischer Systeme liegen die molaren Dotierungskonzentrationen typischerweise im Bereich von 1:10 bis 1:10000. Falls die Dotanden wesentlich kleiner sind als die Matrixmoleküle, können in Ausnahmefällen auch mehr Dotanden als Matrixmoleküle in der Schicht sein (bis 5:1). Die Dotanden können organisch oder anorganisch sein.

Aufgrund der Dotierung der Transportschichten ergeben sich wesentliche Punkte der Erfindung. Zum einen werden durch Dotierung die Transporteigenschaften entscheidend verbessert, so dass Verluste (Potentialabfall am Widerstand) minimiert werden. Weiterhin wirkt die Dotierung vorteilhaft auf das Rekombinations- bzw. Generationsverhalten am Übergang zwischen zwei pin-Zellen. Hohe Dotierung bedeutet in diesem Falle auch eine schmale Verarmungszone auf beiden Seiten dieses Übergangs, so dass auch hohe Barrieren leicht (z.B. durch den quantenmechanischen Tunnelprozess) überwunden werden können. Durch Verwendung von wide-gap Materialien ist dieser pn-Übergang zudem nicht photoaktiv und führt damit bei Beleuchtung nicht zum Aufbau einer Gegenspannung, die die nutzbare Photospannung reduzieren würde.

Eine weitere vorteilhafte Ausführung der o.g. Stapelzelle besteht darin, dass am Übergang zwischen zwei pin-Zellen zusätzlich eine Übergangsschicht (u. U. mehrere Schichten) eingebracht ist. Diese kann dünn ausgeführt sein und der zusätzlichen Einbringung von Rekombinationszentren dienen. Insbesondere ist es zweckmäßig, dass diese aus Metallclustern oder einer ultradünnen Metallschicht besteht (nicht Teil der beanspruchten Erfindung).

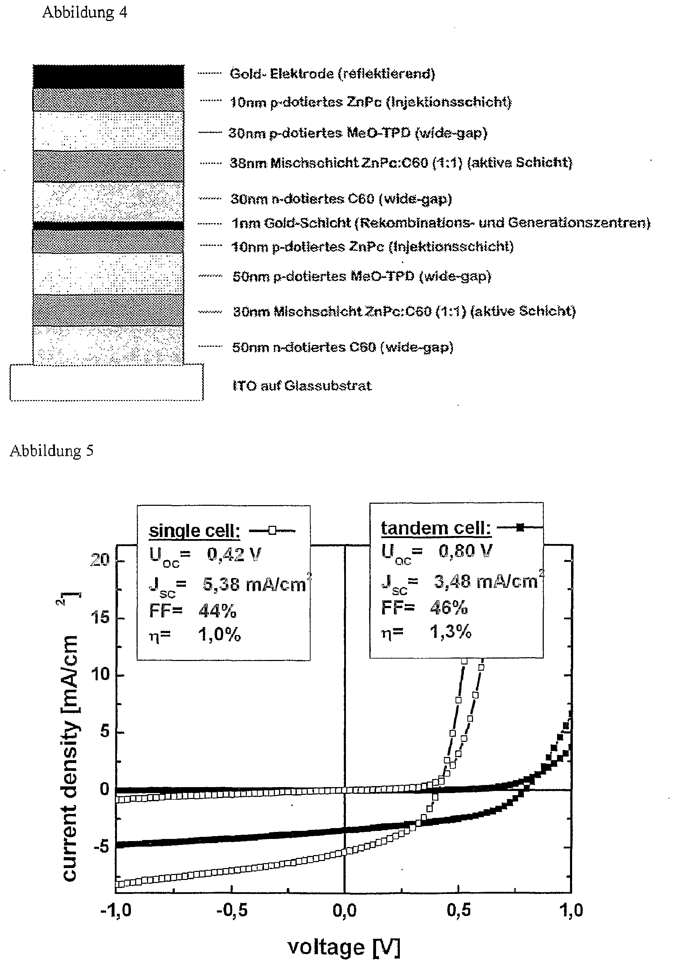

Zur Demonstration der Funktion der oben genannten pin-Einfachstruktur und einer pin-Zweifachstruktur sind in Abb. 5 je eine Hell- und eine Dunkelkennlinie dargestellt. Abb. 4 gibt die Schichtabfolge der Zweifachstruktur wieder (nicht Teil der beanspruchten Erfindung). Die Einfachstruktur entspricht der ersten Teilzelle (beginnend vom Substrat), wobei anstatt der 1nm dicken Goldschicht eine ca. 40nm Goldschicht zur Kontaktierung aufgebracht ist. Die abgebildeten Zellen sind noch in keiner Weise optimiert. Die annähernde Verdoppelung der offenen Klemmspannung (open circuit voltage Uoc) bestätigt die Funktionsweise.

### Photoaktives Bauelement mit organischen Schichten Liste der Bezugszeichen und verwendeten Abkürzungen

- HOMO: Highest Occupied Molecular Orbital
- LUMO: Lowest Unoccupied Molecular Orbital
- E_{F}: Ferminiveau

- 0a,0b: Substrat
- 1a,1b: Kontaktschicht (meist Transparent)
- 2a,2b: Transportschicht (wide-gap) (p- bzw. n-dotiert)
- 3a,3b: aktive Schicht
- 4a,4b: Transportschicht (wide-gap) (n- bzw. p-dotiert)
- 5a: Kontaktschicht
- 5b: Übergangsschicht
- 6b: Transportschicht (wide-gap) (p- bzw. n-dotiert)
- 7b: aktive Schicht
- 8b: Transportschicht (wide-gap) (n- bzw. p-dotiert)
- (N-l)b: Transportschicht (wide-gap) (n- bzw. p-dotiert)
- Nb: Kontaktschicht

## Patentansprüche

1. Organisches photoaktives Bauelement, insbesondere eine organische Solarzelle, mit organischen Dünnschichten, und mit einer als Grundkontakt (1b) und einer als Deckkontakt (Nb) ausgebildeten Kontaktschicht und zwischen den Kontaktschichten wenigstens zwei Schichtstrukturen, von denen jede Struktur wenigstens eine p-dotierte organische Transportschicht(2b; 4b; 6b; 8b) oder eine n-dotierte organische Transportschicht und eine photoaktive i-Schicht beinhaltet, die in einer pi-, ni-, nip- oder pin-Dioden-Struktur aus jeweils der photoaktiven i-Schicht (3b, 7b, etc.) und einer p- und/oder einer n-Schicht angeordnet sind, wobei
a) die p-Schicht bzw. die n-Schicht aus mindestens einer p-dotierten bzw. n-dotierten Transportschicht besteht und die Dotierung zu einer Erhöhung der Dichte der freien Löcher in der p-Schicht bzw. zu einer Erhöhung der Dichte der freien Elektronen in der n-Schicht jeweils im thermischen Gleichgewicht führt,
b) die i-Schicht als photoaktive Schicht ausgeführt ist,
c) die Schichtstrukturen übereinander gestapelt zwischen dem Grund- und dem Deckkontakt angeordnet sind,
d) die p- oder die n- Schicht (2b; 4b; 6b; 8b; etc.) in jeder Struktur eine größere optische Bandlücke als die photoaktive i-Schicht, (3b; 7b; etc.) in der jeweiligen Struktur aufweist,
e) die n- oder p-Schicht, welche an den Übergang zwischen zwei Strukturen angrenzt, eine Dotierung aufweist und zwischen der n-Schicht und der p-Schicht am Übergang zwischen zwei Strukturen eine oder mehrere dotierte funktionelle Schichten aus einem organischen oder anorganischem Halbleitermaterial, oder eine Schicht aus einem Salz oder einem transparenten leitfähigen Oxid, oder mehrerer dieser Schichten eingebracht sind, und
**f)** die Strukturen zumindest in einem Teil des Sonnenspektrums von 350 nm bis 2000 nm teildurchlässig sind.

2. Photoaktives Bauelement nach Anspruch 1, wobei die n-dotierte bzw. p-dotierte Transportschicht (2b, 4b, 6b, 8b,...) vorteilhafterweise nur im UV- bzw. im UV-nahen Bereich des sichtbaren Sonnenspektrums absorbiert.

3. Photoaktives Bauelement nach Anspruch 1 oder 2, wobei mindestens drei ni-, pi, nip- oder pin-Strukturen zwischen dem Deck- und Grundkontakt gestapelt als Sandwichstruktur vorgesehen sind, wobei das photoaktive Bauelement mehrere i-Schichten aufweist, welche eine Schichtdicke im Bereich von 1 nm bis 1 µm aufweisen.

4. Photoaktives Bauelement nach einem der vorhergehenden Ansprüche, wobei die i-Schicht (3b, 7b, usw.) aus mehreren Schichten besteht, von denen mindestens eine im elektrischen Sinne undotiert oder im Vergleich zu den p-dotierten bzw. n-dotierten Schichten (2b, 4b, 6b, 8b, usw.) geringer dotiert ist, und von denen mindestens eine als Photonen absorbierende und Strom generierende und damit photoaktive Schicht ausgebildet ist.

5. Photoaktives Bauelement nach einem der vorhergehenden Ansprüche, wobei die i-Schicht (3b, 7b, usw.) von mindestens einer der Strukturen aus mehreren Schichten mit verschiedenen Absorptionsspektren besteht.

6. Photoaktives Bauelement nach einem der vorhergehenden Ansprüche, wobei die i-Schichten (3b, 7b, usw.) der einzelnen Strukturen optisch dünn sind, d.h. eine Schichtdicke im Bereich von 1nm bis 1µm aufweisen, und die i-Schichten (3b, 7b, usw.) der einzelnen Strukturen jeweils dieselbe optische Absorption aufweisen oder die i-Schichten (3b, 7b, usw.) der einzelnen Strukturen durch eine Anpassung der Schichtdicken und/oder der Wahl der Materialien verschiedene optische Absorptionsspektren aufweisen, die sich gegenseitig ergänzen.

7. Photoaktives Bauelement nach einem der vorhergehenden Ansprüche, wobei die elektrisch wirksame Dotierung der p-Schicht (2b, 4b, 6b, 8b, usw.) oder der n-Schicht (2b, 4b, 6b, 8b, usw.), die an den Übergang zwischen zwei Strukturen angrenzt, ein Dotierungsverhältnis von Dotandzu Matrixmolekülen
**a)** von 1:10000 bis 5:1 bei einer Dotierung der der p- oder n-Schicht mit Dotanden, die wesentlich kleiner als das Matrixmolekül sind, aufweist oder andernfalls
**b)** von 1:10000 bis 1:10 aufweist.

8. Photoaktives Bauelement nach einem der vorhergehenden Ansprüche, wobei eine oder mehrere Lichtfallen eingesetzt sind, um den optischen Weg des einfallenden Lichtes in der photoaktiven Schicht zu verlängern, wobei
**a)** die Lichtfalle dadurch gebildet ist, dass die dotierte Transportschicht (2b, 4b, 6b, 8b usw.) eine glatte Grenzschicht zu der i-Schicht (3b, 7b) und eine periodisch mikrostrukturierte Grenzfläche zu der Kontaktfläche aufweist, oder
**b)** das Bauelement auf einem periodisch mikrostrukturierten Substrat aufgebaut ist und die dotierte Transportschicht (2b, 4b, 6b, 8b usw.) eine auf der gesamten Fläche homogene Funktion des Bauelements gewährleistend aufgebracht ist.

9. Photoaktives Bauelement nach einem der vorhergehenden Ansprüche, wobei die Dicke der n- bzw. p-Schichten (2b, 4b, 6b, 8b, usw.) so gewählt wird, dass die Position der i-Schicht (3b, 7b, usw.) in Bezug auf die Feldstärkeverteilung des optischen Feldes optimiert ist.

10. Photoaktives Bauelement nach einem der vorhergehenden Ansprüche, wobei die Dicke der Transportschichten (2b, 4b, 6b, 8b, usw.), insbesondere die Dicke der i-Schichten (3b, 7b, usw.), so gewählt ist, dass alle Strukturen unter Berücksichtigung der Verteilung des optischen Feldes in dem photoaktiven Bauelement denselben Photostrom liefern.

11. Photoaktives Bauelement nach einem der vorhergehenden Ansprüche, wobei die Gesamtstruktur mit einem transparenten und einem reflektierenden Kontakt (1b, Nb) versehen ist.

12. Photoaktives Bauelement nach einem der vorhergehenden Ansprüche, wobei der Kontakt (1b, Nb) aus einem transparenten leitfähigen Oxid, vorzugsweise aus Indium-Zinn-OXid (ITO), ZnO:Al oder ZnO, aus anderen transparenten und leitfähigen Materialien, aus leitfähigen Polymere, insbesondere PEDOT:PSS, oder aus leitfähigen Metallen als semitransparente Schicht besteht.

13. Photoaktives Bauelement nach einem der vorhergehenden Ansprüche, wobei die Dotierungsdichte in einer oder mehreren der photoaktiven Schichten (3b, 7b usw.) oder Transportschichten (2b, 4b, 6b, 8b usw.) einen Gradienten aufweist, wobei die Dotierungsdichte in den Transportschichten (2b, 4b, 6b, 8b usw.) in Richtung der aktiven Schicht sinkt.

14. Photoaktives Bauelement nach einem der vorhergehenden Ansprüche, wobei die Komponenten in den photoaktiven Schichten (3b, 7b, usw.), insbesondere auch Mischschichten, aus organischen Materialien bestehen.

15. Photoaktives Bauelement nach einem der vorhergehenden Ansprüche, wobei mindestens ein Dotand ein anorganisches Material, insbesondere ein Alkalimetall ist.

16. Photoaktives Bauelement nach einem der vorhergehenden Ansprüche, wobei mindestens ein Anteil in den photoaktiven Schichten (3b, 7b usw.) ganz oder teilweise aus anorganischen Materialien besteht.

17. Photoaktives Bauelement nach einem der vorhergehenden Ansprüche, wobei mindestens ein Anteil einzelner Transportschichten (2b, 4b, 6b, 8b usw.) ganz oder teilweise aus anorganischen Materialien besteht.

18. Photoaktives Bauelement nach einem der vorhergehenden Ansprüche, wobei für die p-Dotierung der Löchertransportschichten (2b, 4b, 6b, 8b usw.) organische Akzeptormoleküle verwendet werden, ausgewählt aus der Klasse der Chinone, Tetracyanochinodimethane, insbesondere TCNQ-Derivate wie F4-TCNQ, Dicyanochinochinodiimine, insbesondere DCNQI-Derivate, und entsprechende Derivate höherer Chinone, insbesondere Naphto- und Anthrochinonderivate.

19. Photoaktives Bauelement nach einem der vorhergehenden Ansprüche, wobei die p-Transportschichten (2b, 4b, 6b, 8b usw.) aus einem Wirtsmaterial bestehen, wofür ein Material aus den folgenden Materialklassen verwendet wird:
a) Derivate von Tetraphenyldiamin (TPD), insbesondere solche TPD Derivate, deren Ionisierungsenergie durch elektronenschiebende Substituenten wie Methoxy- oder Methylgruppen erniedrigt wird, sowie deren Spiro-Derivate,
**b)** Triphenylamin-Derivate, insbesondere Derivate von Tris(Diphenylamino)-Triphenylamin (TDATA), Triaminophenyl-Derivate, Triphenylbenzen-Derivate und
**c)** Oligomere, die durch Verwendung von Thiophenringen Donorcharakter erhalten, insbesondere Oligothiophene
**d)** Derivate von Oligo-para-Phenylen-Vinylen (OPPV)
**e)** Porphyrine oder Phthalozyanine
**f)** Perylen oder Terrylenderivate.

20. Photoaktives Bauelement nach einem der vorhergehenden Ansprüche, wobei als Wirtsmaterial für die n-Transportschichten ein Material aus den folgenden Materialklassen verwendet wird:
**a)** Derivate von Perylen- oder Naphthalen-Tetracarbonsäure-Diimid (PTCDI, NTCDI), -Dianhydrid (PTCDA, NTCDA) oder -Bisimidazol (PTCBI, NTCBI)
**b)** Fullerene wie C₆₀ oder C₇₀ und deren Derivate
**c)** Phthalozyanine oder Porphyrine, deren Elektronenaffinität durch elektronenziehende Substituenten wie Fluor oder Chlor erhöht wurde
**d)** Chinone
**e)** Oligomere mit durch Substituenten wie Fluor, Chlor, CF_{3'} CN etc. erhöhter Elektronenaffinität, z.B. perfluorierte Oligophenyle
**f)** Oxadiazol-Derivate.

21. Photoaktives Bauelement nach einem der vorhergehenden Ansprüche, wobei in den photoaktiven Schichten (3b; 7b usw.) donorartige Substanzen aus den in Anspruch 19 erwähnten Materialklassen und akzeptorartige Substanzen aus den in Anspruch 20 erwähnten Materialklassen enthalten sind.

## Claims

1. Organic photoactive component, in particular an organic solar cell, having organic thin layers, and having one contact layer in the form of a base contact (1b) and one in the form of a top contact (Nb) and at least two layer structures between the contact layers, of which each structure includes at least one p-doped organic transport layer (2b; 4b; 6b; 8b) or one n-doped organic transport layer and one photoactive i layer, arranged in a pi, ni, nip or pin diode structure composed in each case of the photoactive i layer (3b, 7b, etc.) and a p layer and/or an n layer, wherein
a) the p layer or the n layer consists of at least one p-doped or n-doped transport layer, and the doping leads to an increase in the density of free holes in the p layer or to an increase in the density of free electrons in the n layer, each at thermal equilibrium,
b) the i layer is designed as a photoactive layer,
c) the layer structures are in a stacked arrangement one on top of another between the base contact and the top contact,
d) the p layer or the n layer (2b; 4b; 6b; 8b; etc.) in every structure has a greater optical bandgap than the photoactive i layer (3b; 7b; etc.) in the respective structure,
e) the n layer or p layer adjoining the transition between two structures has doping and one or more doped functional layers of an organic or inorganic semiconductor material, or a layer of a salt or a transparent conductive oxide, or two or more of these layers have been introduced between the n layer and the p layer at the transition between two structures, and
f) the structures are partly transparent at least in part of the solar spectrum from 350 nm to 2000 nm.

2. Photoactive component according to Claim 1, wherein the n-doped or p-doped transport layer (2b, 4b, 6b, 8b, ...) advantageously absorbs solely in the UV or near-UV region of the visible solar spectrum.

3. Photoactive component according to Claim 1 or 2, wherein at least three ni, pi, nip or pin structures have been provided stacked as a sandwich structure between the top contact and base contact, wherein the photoactive component has two or more i layers having a layer thickness in the range from 1 nm to 1 µm.

4. Photoactive component according to any of the preceding claims, wherein the i layer (3b, 7b, etc.) consists of multiple two or more layers, at least one of which is undoped for electrical purposes or has lower doping compared to the p-doped or n-doped layers (2b, 4b, 6b, 8b, etc.), and at least one of which is designed as a photon-absorbing and current-generating and hence photoactive layer.

5. Photoactive component according to any of the preceding claims, wherein the i layer (3b, 7b, etc.) of at least one of the structures consists of multiple two or more layers having different absorption spectra.

6. Photoactive component according to any of the preceding claims, wherein the i layers (3b, 7b, etc.) of the individual structures are optically thin, i.e. have a layer thickness in the range from 1 nm to 1 µm, and the i layers (3b, 7b, etc.) of the individual structures each have the same optical absorption or the i layers (3b, 7b, etc.) of the individual structures have different optical absorption spectra that complement one another by virtue of adjustment of the layer thicknesses and/or choice of materials.

7. Photoactive component according to any of the preceding claims, wherein the electrically active doping of the p layer (2b, 4b, 6b, 8b, etc.) or of the n layer (2b, 4b, 6b, 8b, etc.) that adjoins the transition between two structures has a doping ratio of dopant molecules to matrix molecules a) of 1:10 000 to 5:1 in the case of doping of the p- or n-layer with dopants significantly smaller than the matrix molecule, or else b) of 1:10 000 to 1:10.

8. Photoactive component according to any of the preceding claims, wherein one or more light traps are used to extend the optical pathway of the incident light in the photoactive layer, wherein
a) the light trap is formed in that the doped transport layer (2b, 4b, 6b, 8b etc.) has a smooth interface with the i layer (3b, 7b) and a periodically microstructured interface with the contact surface, or
b) the component is formed on a periodically microstructured substrate and the doped transport layer (2b, 4b, 6b, 8b etc.) is applied so as to assure homogeneous function of the component over the entire area.

9. Photoactive component according to any of the preceding claims, wherein the thickness of the n layers or p layers (2b, 4b, 6b, 8b, etc.) is chosen such that the position of the i layer (3b, 7b, etc.) is optimized in relation to the field strength distribution of the optical field.

10. Photoactive component according to any of the preceding claims, wherein the thickness of the transport layers (2b, 4b, 6b, 8b, etc.), in particular the thickness of the i layers (3b, 7b, etc.), is chosen such that all structures give the same photocurrent taking account of the distribution of the optical field in the photoactive component.

11. Photoactive component according to any of the preceding claims, wherein the overall structure has been provided with a transparent contact and a reflective contact (1b, Nb).

12. Photoactive component according to any of the preceding claims, wherein the contact (1b, Nb) consists of a transparent conductive oxide, preferably of indium tin oxide (IPO), ZnO:Al or ZnO, of other transparent and conductive materials, of conductive polymers, in particular PEDOT:PSS, or of conductive materials as semitransparent layer.

13. Photoactive component according to any of the preceding claims, wherein the dopant density in one or more of the photoactive layers (3b, 7b etc.) or transport layers (2b, 4b, 6b, 8b etc.) has a gradient, wherein the doping density in the transport layers (2b, 4b, 6b, 8b etc.) falls in the direction of the active layer.

14. Photoactive component according to any of the preceding claims, wherein the components in the photoactive layers (3b, 7b, etc.), in particular also mixed layers, consist of organic materials.

15. Photoactive component according to any of the preceding claims, wherein at least one dopant is an inorganic material, in particular an alkali metal.

16. Photoactive component according to any of the preceding claims, wherein at least one fraction in the photoactive layers (3b, 7b etc.) consists wholly or partly of inorganic materials.

17. Photoactive component according to any of the preceding claims, wherein at least one fraction of individual transport layers (2b, 4b, 6b, 8b etc.) consists wholly or partly of inorganic materials.

18. Photoactive component according to any of the preceding claims, wherein organic acceptor molecules used for the p-doping of the hole transport layers (2b, 4b, 6b, 8b etc.) are selected from the class of the quinones, tetracyanoquinodimethanes, in particular TCNQ derivatives such as F4-TCNQ, dicyanoquino-diimines, in particular DCNQI derivatives, and corresponding derivatives of higher quinones, in particular naphtho- and anthraquinone derivatives.

19. Photoactive component according to any of the preceding claims, wherein the p transport layers (2b, 4b, 6b, 8b etc.) consist of a host material, for which a material from the following material classes is used:
a) derivatives of tetraphenyldiamine (TPD), in particular those TPD derivatives having ionization energy lowered by electron-donating substituents such as methoxy or methyl groups, and the spiro derivatives thereof,
b) triphenylamine derivatives, in particular derivatives of tris(diphenylamino)triphenylamine (TDATA), triaminophenyl derivatives, triphenylbenzene derivatives and
c) oligomers that take on donor character through use of thiophene rings, in particular oligothiophenes,
d) derivatives of oligo-para-phenylene-vinylene (OPPV)
e) porphyrins or phthalocyanines
f) perylene or terrylene derivatives.

20. Photoactive component according to any of the preceding claims, wherein the host material used for the n transport layers is a material from the following material classes:
a) derivatives of perylene- or naphthalene- tetracarboxylic-diimide (PTCDI, NTCDI), -dianhydride (PTCDA, NTCDA) or -bisimidazole (PTCBI, NTCBI)
b) fullerenes such as C₆₀ or C₇₀ and derivatives thereof
c) phthalocyanines or porphyrins, which electron affinity has been increased by electron-withdrawing substituents such as fluorine or chlorine,
d) quinones
e) oligomers having electron affinity elevated by substituents such as fluorine, chlorine, CF₃, CN etc., for example perfluorinated oligophenyls,
f) oxadiazole derivatives.

21. Photoactive component according to any of the preceding claims, wherein the photoactive layers (3b; 7b etc.) include donor-type substances from the material classes mentioned in Claim 19 and acceptor-type substances from the material classes mentioned in Claim 20.

## Revendications

1. Composant photoactif organique, en particulier une cellule solaire organique, comprenant des couches minces organiques et une couche de contact conçue comme un contact de base (1b) et une couche de contact conçue comme un contact de revêtement (Nb) et, entre les couches de contact, au moins deux structures de couche qui contiennent chacune au moins une couche de transport organique dopée p (2b ; 4b ; 6b ; 8b) ou une couche de transport organique dopée n et une couche i photoactive qui sont disposées dans une structure de diode pi, ni, nip ou pin formée respectivement de la couche i photoactive (3b, 7b, etc.) et d'une couche p et/ou d'une couche n,
a) la couche p ou la couche n comprenant au moins une couche de transport dopée p ou dopée n et le dopage entraînant une augmentation de la densité des trous libres dans la couche p ou une augmentation de la densité des électrons libres dans les couches n en équilibre thermique,
b) la couche i étant conçue comme une couche photoactive,
c) les structures de couche étant empilées les unes sur les autres entre le contact de base et le contact de revêtement,
d) la couche p ou la couche n (2b ; 4b ; 6b ; 8b ; etc.) comportant dans chaque structure une bande interdite optique plus grande que la couche i photoactive (3b ; 7b ; etc.) dans la structure respective,
e) la couche n ou p, qui est adjacente à la jonction entre deux structures, présentant un dopage et une ou plusieurs couches fonctionnelles dopées en matériau semi-conducteur organique ou minéral, ou une couche d'un sel ou d'un oxyde conducteur transparent, ou plusieurs de ces couches étant introduites entre la couche n et la couche p à la jonction entre deux structures, et
f) les structures étant partiellement transparentes au moins dans une partie du spectre solaire allant de 350 nm à 2000 nm.

2. Composant photoactif selon la revendication 1, la couche de transport dopée n ou p (2b, 4b, 6b, 8b, ...) n'absorbant avantageusement que dans le domaine UV ou proche des UV du spectre solaire visible.

3. Composant photoactif selon la revendication 1 ou 2, au moins trois structures ni, pi, nip ou pin étant prévues entre le contact de revêtement et le contact de base en étant empilées sous la forme d'une structure en sandwich, le composant photoactif comportant plusieurs couches i qui ont une épaisseur de couche dans la gamme de 1 nm à 1 µm.

4. Composant photoactif selon l'une des revendications précédentes, la couche i (3b, 7b, etc.) comprenant plusieurs couches dont au moins une est non-dopée au sens électrique ou est moins dopée par rapport aux couches dopées p ou n (2b, 4b, 6b, 8b, etc.), et dont au moins une est conçue comme une couche absorbant les photons et générant du courant et donc photoactive.

5. Composant photoactif selon l'une des revendications précédentes, la couche i (3b, 7b, etc.) d'au moins une des structures comprenant plusieurs couches ayant des spectres d'absorption différents.

6. Composant photoactif selon l'une des revendications précédentes, les couches i (3b, 7b, etc.) des structures individuelles étant optiquement minces, c'est-à-dire ayant une épaisseur de couche dans la gamme allant de 1 nm et 1 µm, et les couches i (3b, 7b, etc.) des structures individuelles ayant chacune la même absorption optique ou les couches i (3b, 7b, etc.) des structures individuelles ayant des spectres d'absorption optique qui se complètement mutuellement et qui diffèrent par une adaptation des épaisseurs de couche et/ou par le choix des matériaux.

7. Composant photoactif selon l'une des revendications précédentes, le dopage électriquement efficace de la couche p (2b, 4b, 6b, 8b, etc.) ou de la couche n (2b, 4b, 6b, 8b, etc.), qui est adjacente à la transition entre deux structures, présentant un rapport de dopage du dopant aux molécules de matrice
a) de 1:10000 à 5:1 pour un dopage de la couche p ou n avec des dopants qui sont sensiblement inférieurs à la molécule de matrice, ou sinon
b) de 1:10000 à 1:10.

8. Composant photoactif selon l'une des revendications précédentes, un ou plusieurs pièges de lumière étant utilisés pour prolonger le chemin optique de la lumière incidente dans la couche photoactive,
a) le piège de lumière étant formé du fait que la couche de transport dopée (2b, 4b, 6b, 8b, etc.) comporte une couche limite lisse par rapport à la couche i (3b, 7b) et une surface limite périodiquement microstructurée par rapport à la surface de contact, ou
b) le composant étant construit sur un substrat périodiquement microstructuré et la couche de transport dopée (2b, 4b, 6b, 8b, etc.) étant appliquée pour assurer un fonctionnement homogène du composant sur toute la surface.

9. Composant photoactif selon l'une des revendications précédentes, l'épaisseur des couches n ou p (2b, 4b, 6b, 8b, etc.) étant choisie de manière à optimiser la position de la couche i (3b, 7b, etc.) en termes de distribution d'intensité du champ optique.

10. Composant photoactif selon l'une des revendications précédentes, l'épaisseur des couches de transport (2b, 4b, 6b, 8b, etc.), en particulier l'épaisseur des couches i (3b, 7b, etc.) étant choisie de telle sorte que toutes les structures délivrent le même photocourant en tenant compte de la distribution du champ optique dans le composant photoactif.

11. Composant photoactif selon l'une des revendications précédentes, la structure globale étant munie d'un contact transparent et d'un contact réfléchissant (1b, Nb).

12. Composant photoactif selon l'une des revendications précédentes, le contact (1b, Nb) comprenant un oxyde conducteur transparent, de préférence un oxyde d'indium-étain (ITO), ZnO:Al ou ZnO, d'autres matériaux transparents et conducteurs, des polymères conducteurs, notamment PEDOT:PSS, ou des métaux conducteurs comme couche semi-transparente.

13. Composant photoactif selon l'une des revendications précédentes, la densité de dopage dans une ou plusieurs des couches photoactives (3b, 7b, etc.) ou couches de transport (2b, 4b, 6b, 8b, etc.) présentant un gradient, la densité de dopage dans les couches de transport (2b, 4b, 6b, 8b, etc.) diminuant en direction de la couche active.

14. Composant photoactif selon l'une des revendications précédentes, les composants des couches photoactives (3b, 7b, etc.), notamment également des couches mixtes, comprenant des matériaux organiques.

15. Composant photoactif selon l'une des revendications précédentes, au moins un dopant étant un matériau minéral, notamment un métal alcalin.

16. Composant photoactif selon l'une des revendications précédentes, au moins une partie des couches photoactives (3b, 7b, etc.) comprenant en tout ou partie des matériaux minéraux.

17. Composant photoactif selon l'une des revendications précédentes, au moins une partie des couches de transport individuelles (2b, 4b, 6b, 8b, etc.) comprenant en tout ou partie des matériaux minéraux.

18. Composant photoactif selon l'une des revendications précédentes, des molécules organiques acceptrices étant utilisées pour le dopage p des couches de transport de trous (2b, 4b, 6b, 8b, etc.), lesquelles molécules sont choisies dans la classe des quinones, des tétracyanoquinodiméthanes, en particulier des dérivés du TCNQ tels que le F4-TCNQ, les dicyanoquinodiimines, notamment des dérivés du DCNQI, et des dérivés correspondants des quinones supérieures, notamment des dérivés naphto et anthroquinone.

19. Composant photoactif selon l'une des revendications précédentes, les couches de transport p (2b, 4b, 6b, 8b, etc.) comprenant un matériau hôte pour lequel est utilisé un matériau des classes de matériaux suivantes :
a) les dérivés de la tétraphényldiamine (TPD), en particulier les dérivés de TPD dont l'énergie d'ionisation est abaissée par des substituants donneurs d'électrons tels que des groupes méthoxy ou méthyle, et leurs dérivés spiro,
b) les dérivés de triphénylaraine, en particulier les dérivés de tris(diphénylamino)triphénylamine (TDATA), les dérivés de triaminophényle, les dérivés de triphénylbenzène et
c) les oligomères qui obtiennent un caractère donneur grâce à l'utilisation de cycles thiophènes, en particulier des oligothiophènes
d) les dérivés oligo-para-phénylène-vinylène (OPPV)
e) les porphyrines ou phtalocyanines
f) les dérivés de pérylène ou de terrylène.

20. Composant photoactif selon l'une des revendications précédentes, un matériau des classes de matériaux suivantes étant utilisé comme matériau hôte pour les couches n de transport :
a) les dérivés du diimide (PTCDI, NTCDI), du dianhydride (PTCDA, NTCDA) ou du bisimidazole (PTCBI, NTCBI) de l'acide pérylène- ou naphtalène-tétracarboxylique
b) les fullerènes tels que C₆₀ ou C₇₀ et leurs dérivés
c) les phtalocyanines ou les porphyrines dont l'affinité électronique a été augmentée par des substituants attracteurs d'électron tels que le fluor ou le chlore
d) les quinones
e) les oligomères ayant une affinité électronique augmentée par des substituants tels que le fluor, le chlore, le CF₃, le CN etc., par exemple les oligophényles perfluorés
f) les dérivés d'oxadiazole.

21. Composant photoactif selon l'une des revendications précédentes, des substances de type donneur des classes de matériaux mentionnées à la revendication 19 et des substances de type accepteur des classes de matériaux mentionnées à la revendication 20 étant contenues dans les couches photoactives (3b ; 7b, etc.).
